# DEMANDE DE BREVET EUROPEEN

(11) **EP 1 310 995 A2**
(43) Date de publication de la demande: **14.05.2003**
(21) Numéro de dépôt: 02079626.4
(22) Date de dépôt: 06.11.2002
(51) Int. Cl.: H01L 23/498, H01L 23/50, H01L 23/552

(54) **Dispositif de blindage des lignes de transmission par la masse ou l'alimentation**

(30) Priorité: 13.11.2001 FR 0114664
(71) Demandeur: Koninklijke Philips Electronics N.V., 5621 BA Eindhoven (NL)
(72) Inventeur: Barre, Philippe, Societe Civile S.P.I.D., 75008 Paris (FR); Gloaguen, Gilbert, Societe Civile S.P.I.D., 75008 Paris (FR)
(74) Mandataire: Lottin, Claudine

(57) **Abrégé**

L'invention concerne un circuit intégré muni d'un leu de plots de connexion pour connecter le circuit intégré avec une ligne de transmission différentielle. Le jeu de plots de connexion comporte au moins une première paire de plots de connexion destinés à recevoir une première tension d'alimentation, une deuxième paire de plots de connexion destinés à recevoir une deuxième tension d'alimentation et une troisième paire de plots de connexion, dits plots de signal, destinés à être reliés aux lignes de transmission. Chaque paire de plots d'alimentation peut recevoir indifféremment la masse ou l'une des tensions d'alimentation haute ou basse, réalisant deux configurations d'alimentation possibles, positive ou négative. Les plots de signal sont entourés par les plots d'alimentation de façon à réaliser un blindage spécifique indépendant de la configuration d'alimentation positive ou négative de l'application.

## Description

L'invention concerne le domaine des circuits intégrés. Elle concerne plus particulièrement un dispositif comprenant un circuit intégré et un jeu de plots de connexion pour connecter ledit circuit intégré avec au moins une paire de lignes de transmission destinées à véhiculer des signaux électriques à destination et/ou en provenance dudit circuit intégré, le jeu de plots de connexion comprenant au moins une première paire de plots de connexion destinés à recevoir une première tension de référence, une deuxième paire de plots de connexion destinés à recevoir une deuxième tension de référence et une troisième paire de plots de connexion, dits plots de signal, destinés à être reliés à ladite paire de lignes de transmission.

L'invention concerne également un appareil de télécommunication comportant un tel dispositif.

L'invention a de nombreuses applications dans le domaine des télécommunications, notamment dans les systèmes de transmissions par liaisons optiques. Elle est particulièrement avantageuse dans les applications à haut débits.

Dans les applications de télécommunications utilisant des circuits intégrés à hauts débits, il est souvent indispensable d'utiliser des plots de connexion réalisant des accès d'entrée / sortie différentiels à faible amplitude de tension, par exemple de l'ordre de 0,2 V, notamment du type CML (de l'anglais Common Mode Logic), LVDS (de l'anglais Low Voltage Differential Signalling), ou autres PECL (Positive Emitter Coupled Logic). Ces plots de connexion sont destinés à être connectés à des lignes de transmissions différentielles véhiculant des signaux différentiels matérialisées par des pistes tracées sur un circuit imprimé (PCB). Les pistes doivent de préférence être protégées les unes des autres contre des perturbations électromagnétiques environnantes, notamment des interférences ou du bruit. Ces perturbations sont en effet susceptibles de modifier sensiblement le fonctionnement normal et les performances des circuits intégrés.

Le brevet américain n° 6 215 184, décrit une méthode pour réaliser un tracé de connexions pour connecter des circuits intégrés sur un circuit imprimé au moyen d'un jeu de points de connexion. La méthode décrite ne suggère aucun moyen de blindage spécifique contre le bruit et les interférences générés dans les circuits. Elle ne suggère pas non plus comment rendre ces moyens indépendants de la configuration d'alimentation choisie. Selon l'application considérée, les circuits peuvent être alimentés selon l'une ou l'autre des configurations d'alimentation possibles, dites positive et négative. Selon la configuration positive, la masse correspond à la tension basse. Selon la configuration négative, la masse correspond à la tension haute. Le schéma de blindage impose par ailleurs et dans la mesure du possible, d'encadrer le signal par une référence "propre", c'est-à-dire non parasitée, réalisant ainsi un chemin de retour électromagnétique pour le signal qui soit le moins bruité possible. En général, cette référence "propre" est reliée à la masse. Selon la configuration d'alimentation de l'application, positive ou négative, le schéma de blindage peut donc s'en trouver modifié, ce qui augmente le coût des circuits en nécessitant éventuellement de prévoir un jeu de plots de connexions adapté pour chaque configuration d'alimentation.

Un objet de l'invention est de fournir un tel jeu de connexions qui comporte des moyens de blindage spécifiques utilisables quelle que soit la configuration d'alimentation choisie.

Pour cela, il est prévu un circuit intégré du genre mentionné dans le paragraphe introductif remarquable en ce que lesdits plots de signal sont entourés par lesdites première et deuxième paires de plots de connexion.

La description suivante, donnée à titre d'exemple non limitatif pour illustrer comment l'invention peut être réalisée, est faite en regard des dessins ci-annexés, parmi lesquels :
- la figure 1 est un schéma pour illustrer un exemple de réalisation d'un circuit selon l'invention, selon deux configurations d'applications, illustrées aux figures 1A et 1B,
- la figure 2 est un schéma pour illustrer trois autres exemples de réalisation de l'invention, illustrés aux figures 2A, 2B et 2C, respectivement.

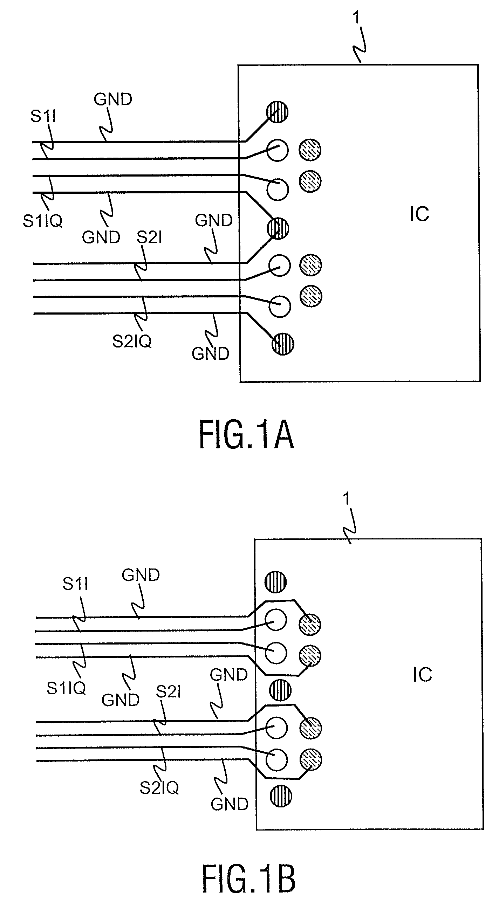

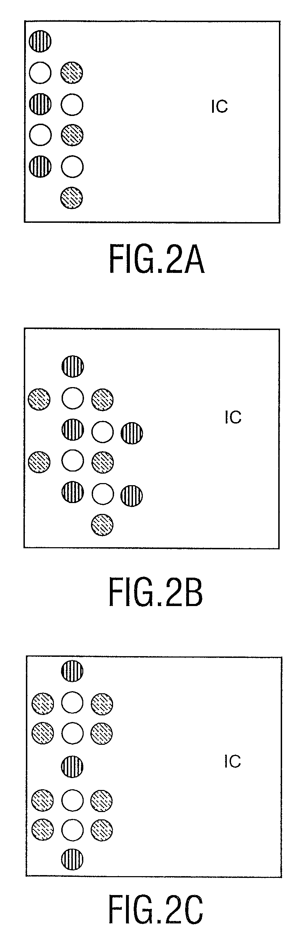

Dans des applications utilisant des circuits intégrés fonctionnant à haut débit, telles que les transmissions optiques, les signaux transmis sont de type différentiels. Ils sont couramment représentés par des signaux complémentaires, appelés composantes I et IQ du signal différentiel lorsqu'il s'agit de signaux entrant et composantes O et OQ lorsqu'il s'agit de signaux sortant. Les exemples illustrés dans les figures 1 et 2 concernent des signaux entrant mais l'invention s'applique également en sortie des circuits, aux jeux de connexions délivrant les signaux sortant. Les deux composantes I et IQ du signal différentiel sont véhiculées sur deux fils simultanément. La différence entre les deux composantes du signal peut par exemple être assimilée à une suite de données numériques binaires de type "0" ou "1".

La figure 1 montre un exemple de réalisation préféré d'un circuit intégré selon l'invention, noté IC, connecté à une première et une deuxième lignes de transmission différentielles parallèles, notées S1 et S2 respectivement. L'invention est applicable de façon identique à une seule ligne de transmission. La présence d'une ou de deux lignes S1 et S2 et des plots de connexion associés sur les figures 1 à 3, est destinée à montrer comment plusieurs lignes peuvent être connectées à l'aide d'un dispositif selon l'invention. La première ligne S1 se décompose en une première composante, notée S1I, et une deuxième composante, notée S1IQ. La deuxième ligne S2 se décompose en une première composante, notée S2I et une deuxième composante, notée S2IQ. Chaque composante I ou IQ du signal différentiel comporte à son tour deux voies distinctes comprenant une première voie ou ligne directe transportant le signal utile à transmettre et une deuxième voie ou ligne de retour portée à une tension de référence dépendant de l'application.

Les lignes différentielles transportent les composantes I et IQ des signaux différentiels à transmettre. Elles sont matérialisées par des pistes réalisées avec un matériau conducteur tracées ou imprimées sur un support en matériau isolant. L'ensemble des pistes tracées forme un circuit, couramment appelé circuit imprimé ou PCB, destiné à interconnecter des circuits intégrés (un seul circuit intégré est représenté sur la figure 1) selon un routage prédéterminé en fonction de l'application envisagée. Les circuits intégrés sont généralement situés à l'intérieur de boîtiers 1 réalisés en matériau isolant. Les connexions entre les lignes imprimées et les circuits intégrés sont réalisées au moyen d'un jeu de plots de connexions, représentés sur la figure par des cercles. Dans le cas où le circuit est intégré dans un boîtier de type BGA (de l'anglais Ball Gate Array) les plots de connexion sont pratiquement sphériques et sont appelés des balles de connexion. Le jeu de plots de connexions comporte des connexions destinées à recevoir les signaux différentiels à transmettre, dits plots de signal et des connexions destinées à l'alimentation des circuits, dits plots d'alimentation. L'alimentation se fait à l'aide de deux tensions d'alimentation distinctes, l'une étant supérieure à l'autre et l'une correspond généralement à la masse. Les plots d'alimentation sont donc soumis à une tension de référence parmi deux tensions de référence distinctes possibles, l'une dite référence haute et l'autre dite référence basse. Les plots d'alimentation sont représentées par des cercles hachurés. Par convention, sur la figure 1, les hachures verticales correspondent aux plots reliés à la référence basse et les hachures en biais correspondent aux plots reliés à la référence haute.

Deux configurations d'alimentation sont alors possibles pour le circuit intégré. Selon une première configuration, dite configuration positive, la tension de référence basse correspond à la masse et la tension de référence haute correspond à une tension constante positive, notée + VCC. Selon la deuxième configuration, dite configuration négative, la tension de référence basse correspond à une tension constante négative, notée -VCC et la tension de référence haute correspond à la masse. Les circuit intégrés peuvent donc être alimentés selon l'une ou l'autre de ces configurations au choix. En revanche, l'application envisagée n'a en général qu'une seule tension de référence, par exemple la masse. Dans ce cas, il est préférable que les lignes de retour des lignes différentielles soient reliées à la masse. Or, selon la configuration d'alimentation du circuit imprimé, la masse n'est pas reliée aux mêmes plots de connexions, ce qui implique que le traçage des pistes imprimées peut être différent d'une configuration à l'autre comme le montrent les figures 1A et 1B.

La figure 1A illustre un exemple de réalisation d'un circuit selon l'invention dans la configuration positive. La figure 1B illustre le même circuit selon la configuration négative. Les plots de signal, représentés sur les figures 1A et 1B par des cercles non hachurés, sont situées en bordure du boîtier et sont entourés par les plots d'alimentation qui recoivent des tensions de référence constantes. De préférence, la disposition des paires de plots de connexion est symétrique par rapport à un plan perpendiculaire au plan du PCB et perpendiculaire au coté du boîtier le plus proche du jeu de plots de connexions considérées. Cette disposition des plots de connexion est compatible avec les deux configurations d'alimentation possibles. Dans chaque configuration, les lignes de transmission directes ainsi que les plots de signal auxquelles elles sont connectées sont encadrées par la masse ou l'alimentation, selon la configuration utilisée, formant ainsi un écran de protection contre d'éventuelles perturbations électromagnétiques générées par les signaux transmis à haute fréquence.

Le dispositif illustré aux figures 1A et 1B présente de nombreux avantages. Un premier avantage est la facilité d'accès des plots de signal. Les plots de signal sont disposés au bord du boîtier pour permettre un accès direct aux lignes de transmission. Un deuxième avantage est la symétrie du dispositif. Les plots de connexion sont disposés sur le boîtier de façon symétrique par rapport à un plan perpendiculaire au plan du circuit intégré et passant parallèlement aux lignes de transmission par un point milieu séparant lesdites lignes de transmission. Ce qui signifie que les distances parcourues par le signal peuvent être les mêmes sur chaque composante différentielle complémentaire SI et SIQ de la ligne de transmission, avec tous les avantages bien connus que cela implique. Un troisième avantage est la qualité du blindage. Chaque paire de lignes de transmission est encadrée jusqu'au plot de signal par deux lignes de référence propres, non bruitées, ce qui favorise une bonne transmission des signaux.

La figure 2 montre trois autres exemples de réalisation de l'invention. Ces trois exemples sont donnés à titre indicatif et non restrictif. Ils peuvent donner lieu à de nombreuses variantes sans sortir du cadre de l'invention. Les éléments communs avec la figure 1 portent les mêmes références.

La figure 2A illustre une variante dans laquelle les plots de signal sont disposés sur deux rangées parallèles au coté du boîtier décalées en quinconce pour en limiter l'encombrement. Les plots d'alimentation sont disposés autour et entre les plots de signal sur les mêmes rangées parallèles. En revanche, ce mode de réalisation n'est pas symétrique et l'accès aux signaux est moins direct que dans le mode de réalisation illustré à la figure 1.

La figure 2B illustre une autre variante de réalisation. Selon cette variante, les plots de signal sont toujours disposés en quinconce sur deux rangées parallèles mais les plots d'alimentation sont disposés sur quatre rangées parallèles et notamment entre les plots de signal sur les deux rangées de plots de signal, de sorte que chaque plot de signal est entouré aux quatre cotés par au moins un plot d'alimentation. Ce mode de réalisation permet également de limiter l'encombrement des plots de connexion et donc d'en disposer un plus grand nombre sur le boîtier. Il permet également d'ajouter de façon simple d'autres rangées ou couches de plots de connexion vers le centre du boîtier. En revanche, ce mode de réalisation n'est pas symétrique.

La figure 2C illustre encore une autre variante de réalisation. Selon cette variante, les plots de signal sont disposés par paires successives séparées par au moins un plot d'alimentation sur une même rangée parallèle au coté du boîtier. Les autres plots d'alimentation sont disposés de part et d'autre de la rangée de plots de signal de façon à entourer chaque paire de plots de signal. Ce mode de réalisation a l'avantage d'être symétrique et d'offrir un bon blindage des lignes de transmission mais il est plus encombrant que les mode de réalisation précédents.

On a ainsi décrit et illustré à l'aide d'exemples un circuit intégré selon l'invention dans une application impliquant une paire de lignes de transmission différentielles. D'autres variantes de réalisation pourront être envisagées en fonction de l'application considérée sans sortir du cadre de l'invention, notamment en ce qui concerne la position respective et le nombre des plots de connexion sur le boîtier du circuit intégré.

## Revendications

1. Dispositif comprenant un circuit intégré et un jeu de plots de connexion pour connecter ledit circuit intégré avec au moins une paire de lignes de transmission destinées à véhiculer des signaux électriques à destination et/ou en provenance dudit circuit intégré, le jeu de plots de connexion comprenant au moins une première paire de plots de connexion destinés à recevoir une première tension de référence, une deuxième paire de plots de connexion destinés à recevoir une deuxième tension de référence et une troisième paire de plots de connexion, dits plots de signal, destinés à être reliés à ladite paire de lignes de transmission, **caractérisé en ce que** lesdits plots de signal sont entourés par lesdites première et deuxième paires de plots de connexion.

2. Dispositif selon la revendication 1, dans lequel ladite paire de lignes de transmission comprend deux composantes pour transmettre en parallèle des signaux électriques différentiels simultanément, chaque composante étant reliée à un plot de signal distinct.

3. Dispositif selon la revendication 1 ou 2, dans lequel les première et deuxième tensions de référence correspondent à des tensions d'alimentation dudit circuit intégré, dont une tension d'alimentation, dite tension haute, est supérieure à l'autre, dite tension basse, une seule tension d'alimentation correspondant à la masse, réalisant ainsi deux possibilités de configurations d'alimentation distinctes, dites configurations positive et négative, selon que la masse correspond à la tension haute ou basse, respectivement.

4. Dispositif selon la revendication 3, dans lequel la paire de lignes de transmission est associée à une paire de lignes de retour destinées à véhiculer lesdits signaux électriques en sens inverse, **caractérisé en ce que** la paire de plots de connexion destinée à recevoir la masse est destinée à être reliée à ladite paire de lignes de retour.

5. Dispositif selon l'une des revendications 1 à 4 , dans lequel les paires de plots de connexion sont disposés symétriquement par rapport à un plan perpendiculaire au plan du circuit intégré et passant parallèlement aux lignes de transmission par un point milieu séparant lesdites lignes de transmission.

6. Dispositif selon l'une des revendications 1 à 4, dans lequel le circuit intégré est intégré dans un boîtier, **caractérisé en ce que** les plots de signal sont disposés en bordure du boîtier de façon à être immédiatement accessibles par les lignes de transmission.

7. Dispositif selon la revendications 6 , dans lequel le boîtier est du type BGA (de l'anglais Ball Gate Array).

8. Circuit imprimé comportant un support en matériau isolant pour supporter un dispositif selon l'une des revendications 1 à 7, **caractérisé en ce que** les lignes de transmission et les lignes de retour sont imprimées sur ledit circuit.

9. Appareil de télécommunication comportant un dispositif selon l'une des revendications 1 à 8.
